# EUROPEAN PATENT APPLICATION

(11) **EP 2 565 298 A1**
(43) Date of publication of application: **06.03.2013**
(21) Application number: 11774844.2
(22) Date of filing: 18.04.2011
(51) Int. Cl.: C25D 7/06, B32B 15/08, C22C 9/00, H05K 1/03, H05K 1/09

(54) **LAMINATE FOR FLEXIBLE WIRING**

(30) Priority: 30.04.2010 JP 2010105503
(71) Applicant: JX Nippon Mining & Metals Corporation, Tokyo 100-8164 (JP)
(72) Inventor: YAMANISHI Keisuke, Hitachi-city Ibaraki 317-0056 (JP); ARAI Hideta, Hitachi-city Ibaraki 317-0056 (JP); MIKI Atsushi, Hitachi-city Ibaraki 317-0056 (JP)
(74) Representative: Hoarton, Lloyd Douglas Charles
(86) International application number: PCT/JP2011/059485
(87) International publication number: WO 2011/136061

(57) **Abstract**

A laminate for flexible wiring in which copper plating is entirely or locally applied on a copper foil that is cladded on an insulating resin substrate, characterized in that a ratio A = [(200)/{(111) + (200) + (220) + (311)}] × 100, i.e. a ratio of an area intensity of a peak in the X-ray diffraction of the copper plating surface is more than 90. The present invention can provide the laminate for flexible wiring in which copper plating is entirely or locally applied on a copper foil cladded on an insulating resin substrate, characterized in having particularly high bendability and enables the formation of fine patterns, namely, high dense patterns of wiring.

## Description

### TECHNICAL FIELD

The present invention relates to a laminate for flexible wiring in which copper plating is entirely or locally applied on a copper foil that is cladded on an insulating resin substrate, and particularly to a laminate for flexible wiring, which has high bendability and enables the formation of fine patterns, namely, high dense patterns of wiring.

### BACKGROUND ART

With the development of miniaturization and integration technologies of surface mounted components such as semiconductor devices and various electronic chip components, further fine patterning of wiring and bendability of the laminate have recently been demanded for a printed wiring board which is processed from laminate for flexible wiring, on which these surface mounted components are mounted.

A printed wiring board including an organic matter as a base material is roughly classified into a hard copper clad laminate (rigid) including glass epoxy and paper phenol substrates as constituent materials, and a flexible copper clad laminate including a polyimide or polyester substrate as a constituent material, and a copper foil is mainly used as a conductive material of the printed wiring board. The copper foil is classified into an electrolytic copper foil and a rolled copper foil depending on its production method.

The above flexible printed circuit board (FPC) is formed by laminating a copper foil to a resin substrate, followed by integration with an adhesive or by heating under pressure. A rolled copper foil is mainly used as a copper foil which serves as a component of FPC.

FPC is widely used in a place where wiring to movable portions is required such as a head portion of a printer, and a drive section in a hard disk, and bending is repeated millions of times or more. With the progress of miniaturization and increase in level of devices in recent years, requirements for bendability have become more stringent.

Tough pitch copper having an oxygen content of 100 to 500 ppm is mainly used as a material of a rolled copper foil to be used in FPC. This tough pitch copper foil is produced by subjecting an ingot to hot rolling, and then repeating cold rolling and annealing until the thickness reaches a predetermined thickness. Thereafter, a surface of the copper foil is subjected to roughening plating so as to improve adhesion to a resin substrate. After roughening plating, the copper foil is cut and then bonded with a resin substrate.

It is possible to employ a method in which a copper foil and an insulating resin are allowed to undergo thermo-compression bonding, and a resin layer made of a polyimide resin may be formed on the copper foil. There is no particular limitation on the means; for example, it is possible to use, as a raw material, a polyamic acid varnish (a mixture containing polyamic acid obtained by addition polymerization of aromatic diamines and an aromatic acid dianhydride in a state of a solution).

This polyamic acid varnish is applied on a copper foil of the present invention and then dried to form a polyamic acid layer as a polyimide precursor layer. The obtained polyamic acid layer is imidated by heating at 300°C to 400°C under an inert atmosphere such as nitrogen, and thus a polyimide-based resin layer can be formed. There is no particular limitation on the thickness of the polyimide-based resin layer, and the thickness is usually set in the range of 10 to 50 µm. The polyamic acid varnish may be optionally mixed with conventionally known additives. In the flexible printed circuit board thus obtained, satisfactory adhesive strength between the copper foil and polyimide-based resin layer of the present invention is obtained.

Bendability of the copper foil is improved by performing recrystallization annealing. Therefore, the copper foil is used as a component of FPC in an annealed state, and this annealing is performed by subjecting to a heat treatment after roughening plating and then cutting, or a heating in case of bonding a copper foil with a resin substrate also serves as the heat treatment. As described above, the reason why annealing is performed in the process of the whole production process without using a copper foil in an annealed state from the beginning is as follows. That is, in a soft state after annealing, a copper foil may cause deformation or formation of wrinkles when the copper foil is cut or laminated to a resin substrate.

In order to enhance bendability of FPC, it is effective to enhance bendability of the copper foil which serves as the material. Bendability of the copper foil after annealing is improved as a cube texture is more developed. In order to develop the cube texture, it is effective to increase the degree of working in a final rolling and to decrease the grain size in annealing immediately before a final rolling in the production process of a copper foil, for example, a rolled copper foil.

In the flexible printed wiring board, for example, there are a single-sided flexible printed wiring board in which a conductor layer composed of a copper foil is formed on one surface of an insulating resin of a polyimide or polyester substrate, and a double-sided flexible printed wiring board in which a conductor layer is formed on both surfaces of an insulating resin composed of polyimide, polyester or the like.

With the advancement of functions of an electronic device, a double-sided flexible printed wiring board has become widely used in place of a single-sided flexible wiring board so as to achieve high dense pattern of a flexible printed wiring board. Therefore, the development of the double-sided flexible printed wiring board to bending applications is required. In the double-sided flexible printed wiring board, via holes (through-holes) or the like are used for electrical connection of a conductor layer provided on both surfaces of a polyimide resin, and metal plating, mainly copper plating, is often applied on through-holes and a copper foil as a conductor layer for connection of via holes (through-holes). Thereby, in the double-sided flexible printed wiring board, a copper foil layer with copper plating is formed as a conductor layer.

In a double-sided flexible printed wiring board including this copper foil layer with copper plating, crystal grains of electrolytic copper plating are formed on the copper foil in addition to mere increase in thickness of metal layers (copper foil layer + copper plating layer). This is causing a problem that bendability of metal layers drastically deteriorates and the double-sided flexible printed wiring board is not suited for bending applications. Thus, some proposals have been made so as to improve bendability, and they are described below.

Patent Literature 1 mentioned below proposes that penetrating through-holes are formed on a flexible substrate in which a metal layer is provided on both surfaces of an insulating film, and the periphery of through-holes is etched thereby reducing the thickness to 1/2 of a metal foil (thinning) and then a plating layer is formed on the through-hole portion and the thinned portion of the metal foil thereby conducting metal foils on both surfaces, and thus improving bendability and flexibility.

In this case, it is expected that bendability and flexibility will be improved since the thickness of the metal foil does not surely vary. However, there are drawbacks; that is, extremely high plating accuracy is required so that a plating layer with small plating area and small in thickness should be formed. The other drawback is that wiring density cannot be improved in the case that through-holes are densely arranged.

Patent Literature 2 mentioned below proposes that penetrating through-holes are formed on a flexible substrate in which a metal layer is provided on both surfaces of an insulating film, and plating is applied only on an inner surface of through-holes and one surface of the metal layer, while plating is not applied on the other surface of the metal layer. In this case, since a new plating layer is formed only on one surface, it is expected that an area of the plating layer is reduced to half, that is, one of the two surfaces, which will improve bendability and flexibility compared with the case of applying on both surfaces.

However, in this case, the problem is that, when one surface is electrically connected to the other surface via through-holes, one surface conducts in a large area, whereas, the other copper layer conducts in a very small area of only a partial sectional area of the copper layer. Moreover, in the case when a smooth interface is not formed on a copper layer in forming through-holes, there is a problem that it becomes impossible to electrically connect to through-holes, what is more, to electrically connect to the other surface.

Patent Literature 1: Japanese Patent Published Unexamined Application No.2003-188535
Patent Literature 2: Japanese Patent Published Unexamined Application No.2005-251926

### SUMMARY OF THE INVENTION

### [Problems to be solved by the Invention]

The present invention has been made in light of the above-mentioned problems, and an object thereof is to provide a laminate for flexible wiring in which copper plating is entirely or locally applied on a copper foil cladded on an insulating resin substrate, and particularly to a laminate for flexible wiring which has high bendability and enables the formation of fine patterns, namely, high dense patterns of wiring.

### [Problem to be Solved by the Invention]

In light of the above, the present invention provides the following inventions.
1. A laminate for flexible wiring in which copper plating is entirely or locally applied on a copper foil cladded on an insulating resin substrate, characterized in that a ratio A = [(200)/{(111) + (200) + (220) + (311)}] × 100, i.e. a ratio of an area intensity of a peak in the X-ray diffraction of the copper plating surface is more than 90.
2. The laminate for flexible wiring according to the above 1, wherein the copper plating has a thickness of 3 µm or more and 15 µm or less.
3. The laminate for flexible wiring according to the above 1 or 2, wherein a grain size in a cross section of the copper plating portion is 20 µm or more.
4. The laminate for flexible wiring according to any one of the above 1 to 3, wherein a grain size in a cross section of copper foil portion of the laminate for flexible wiring is 30 µm or more.
5. The laminate for flexible wiring according to any one of the above 1 to 4, wherein a ratio A = [(200)/{(111) + (200) + (220) + (311)}] × 100, i.e. a ratio of an area intensity of a peak in the X-ray diffraction of a copper foil after removing copper plating of a laminate for flexible wiring is 95 or more.
6. The laminate for flexible wiring according to any one of the above 1 to 5, wherein a copper foil, in which a ratio A = [(200)/{(111) + (200) + (220) + (311)}] × 100, i.e. a ratio of an area intensity of a peak in the X-ray diffraction after annealing at 350°C for 30 minutes is 95 or more, is used.
7. The laminate for flexible wiring according to any one of the above 1 to 6, wherein the copper foil is a rolled copper foil which contains 0.01 to 0.04% by mass of Ag, 0.01 to 0.05% by mass of oxygen and the remainder being Cu and inevitable impurities.

### [Effects of Invention]

The present invention has an effect of providing a laminate for flexible wiring in which copper plating is entirely or locally applied on a copper foil cladded on an insulating resin substrate, and particularly a laminate for flexible wiring, which has high bendability and enables the formation of fine patterns, namely, high dense patterns of wiring.
In this case, it is possible to provide a laminate for flexible wiring in which copper plating is possible in either case when applied entirely on a copper foil cladded on an insulating resin substrate, or when applied locally on the periphery of through-holes.
The present invention also has the effect capable of applying to either a single-sided flexible wiring board or a double-sided flexible printed wiring board, and thus improving bendability (flexibility).

### BRIEF DESCRIPTION OF THE DRAWINGS

Fig. 1 is a diagram showing the evaluation results of an X-ray diffraction intensity of each of Example 1, Comparative Example 1 and Comparative Example 2.
Fig. 2 is a diagram describing outline of a bending test of a laminate for flexible wiring.
Fig. 3 is a diagram showing the results of a bending test of laminates for flexible wiring of Example 1(1), Comparative Example 1 (2) and Comparative Example 2 (3), and shows the number of bending times until fracture occurs.

### DETAILED DESCRIPTION OF THE INVENTION

A laminate for flexible wiring is a laminate for flexible wiring in which copper plating is entirely or locally applied on a copper foil cladded on an insulating resin substrate, and meets the condition that a ratio A = [(200)/{(111) + (200) + (220) + (311)}] × 100, i.e. a ratio of an area intensity of a peak in the X-ray diffraction of the copper plating surface is more than 90. This ratio of an area intensity of a peak in the X-ray diffraction of the copper plating surface is also influenced by a copper layer. If the area intensity ratio of an X-ray peak of a final plating surface meets the above condition, it is possible to improve high bendability (flexibility) of the laminate for flexible wiring.

When X-ray diffraction intensity of the surface of the copper plating is measured, X-ray peaks (111), (200), (220) and (311) appear, and it is necessary that a ratio of an area intensity of an X-ray peak (200) to an area intensity in total of X-ray peaks (111), (200), (220) and (311) is more than 90. Thereby, a laminate for flexible wiring having high bendability (flexibility) can be obtained.
A polyimide resin or polyester resin substrate can be suitably used as an insulating resin substrate. The insulating resin substrate should not be limited to the above-mentioned insulating resin substrates, and other resins can also be used as long as they have flexibility (endurance in bending) and thermo-bondability to a copper foil.

### (Method for Measurement of X-Ray Diffraction Intensity of Laminate for Flexible Wiring)

The measurement of an X-ray diffraction intensity of a laminate for flexible wiring which is copper plated, of the present invention can be conducted by the following procedure.
A copper foil and an insulating polyimide resin with an adhesive (CISV1215, manufactured by Nikkan Industries Co., Ltd.) are bonded each other by a hot press (at 180°C for 60 minutes) to produce a copper clad laminate. Next, a copper foil surface (glossy surface) of this copper clad laminate is subjected to surface washing (pickling) and then is copper plated. Thereby, a laminate for flexible wiring, including a copper foil with copper plating formed thereon, is produced.

A laminate piece for flexible wiring in a size of 1 cm square is cut out from this laminate sample sheet for flexible wiring. And the laminate piece for flexible wiring is mounted on an X-ray diffractometer (RINT2000, manufactured by Rigaku Co., Ltd.), and then an X-ray diffraction intensity is measured.
From a peak intensity of each of peaks (111), (200), (220) and (311) identified as copper, an X-ray diffraction intensity ratio A = [(200)/{(111) + (200) + (220) + (311)}] × 100 is derived.

### (Adjustment of Thickness and X-Ray Diffraction Intensity of Copper Plating of Laminate for Flexible Wiring)

X-ray diffraction intensity may sometimes vary depending on the thickness of copper plating of a laminate for flexible wiring. Therefore, it is necessary that the above X-ray diffraction intensity ratio A = [(200)/{(111) + (200) + (220) + (311)}] × 100 is measured relative to "maximum thickness of copper plating", In this case, it is desired that a cross section is observed in a state where copper plating is applied on a copper foil, and a maximum value is determined from the measurements at arbitrary 10 points assuming that a depth direction from a plating surface is a thickness, and then an X-ray diffraction intensity at the point of the maximum value is measured.
However, if a portion of the laminate for flexible wiring is known to be thick structurally, the value of the portion may be regarded as a maximum value.

The reason why adjustment is necessary for the thickness of copper plating of a laminate for flexible wiring and the X-ray diffraction intensity is as follows: from the viewpoint of bendability of the laminate for flexible wiring, even if a portion other than the portion is thin and has bendability, when the thick portion is inferior in bendability; the laminate for flexible wiring is also inferior in bendability due to an influence of the thick portion.
Thus, if the thick portion of the laminate for flexible wiring meets the condition of the present invention, a copper plating portion having a smaller thickness inevitably meets the condition of the present invention.

A desired form of the laminate for flexible wiring is that the copper plating has a thickness of 3 µm or more and 15 µm or less. Also in this case, since the thickness of copper plating of a laminate for flexible wiring may sometimes vary, preferred condition of this desired form is that the thickest portion of copper plating is set to 3 µm or more and 15 µm or less. The present invention provides a laminate for flexible wiring, which meets this preferred condition.
The thickness of copper plating can be easily calculated by respectively subtracting known thicknesses of a resin film and a copper foil from the thickness of the entire laminate for flexible wiring (total thickness).

A desired form is that a grain size in a cross section of the copper plating portion is 20 µm or more. The crystal grain has a form of such as spherical, oval or rectangular. In this case, the above numerical value means a major diameter. The larger the grain size is, the richer bendability (flexibility) a laminate for flexible wiring has. The present invention provides such a laminate for flexible wiring.

While copper plating has been described above, bendability (flexibility) is also influenced by properties of a copper foil cladded on one or both surfaces of the laminate for flexible wiring. In particular, a grain size in a cross-section of copper foil portion is 30 µm or more, preferably. The crystal grain has a form of such as spherical, oval or rectangular, and in this case, the above numerical value means a major diameter. The larger the grain size is, the richer bendability (flexibility) a laminate for flexible wiring has. The present invention provides such a laminate for flexible wiring.

One of desired mode is that a ratio A = [(200)/{(111) + (200) + (220) + (311)}] × 100, i.e. a ratio of an area intensity of a peak in the X-ray diffraction of the copper foil surface after removing copper plating of a laminate for flexible wiring is 95 or more. It is very difficult to measure an area intensity of an X-ray peak of copper plating per se which is a thin layer. Thus, an area intensity of an X-ray peak in the X-ray diffraction of the copper plating surface after plating copper foil with copper is measured. Since an area intensity of an X-ray peak of copper plating is likely to be influenced by a copper foil as a under-layer, it can be said that preferably, a ratio A of an area intensity of a peak in the X-ray diffraction of a copper foil is set to 95 or more which is higher than that of a copper plating. The present invention also provides such a laminate for flexible wiring.

Similarly, it is preferred to use a copper foil in which a ratio A = [(200)/{(111) + (200) + (220) + (311)}] × 100, i.e. a ratio of an area intensity of a peak in the X-ray diffraction after annealing at 350°C for 30 minutes is 95 or more. Since the laminate for flexible wiring is exposed to heat, preferred condition of the copper foil is that a ratio A of an area intensity of a peak of copper foil is 95 or more which is higher than that of copper plating. The reason is the same as described above. The present invention also provides such a laminate for flexible wiring.

As a most preferred material of the copper foil, recommended to use is a rolled copper foil which contains 0.01 to 0.04% by mass of Ag, 0.01 to 0.05% by mass of oxygen and the remainder being Cu and inevitable impurities. The material is a copper foil characterized by excellent bendability. The copper foil having high bendability may also be a rolled copper foil containing 0.001 to 0.009% by mass of Sn and the remainder being Cu and inevitable impurities.

The thickness of a copper foil required for use as high density wiring is preferably 18 µm or less, and more preferably 3 to 12 µm. However, a copper foil treatment in the present invention can be applied without any limitation in thickness and applied to an ultra-thin foil or thick copper foil similarly.
It is also possible to apply a roughening treatment, and other surface treatments such as a chromium-based metal, zinc-based metal and organic rust-proof treatments as needed. A coupling treatment of silane or the like is also possible.
These treatments are appropriately selected according to applications of a copper foil of a printed wiring board, and the present invention includes all of them.

### [Examples]

Copper plating conditions used in these Examples and Comparative Examples are shown below.

### Plating liquid

Copper: 18 to 25 g/L
Sulfuric acid: 150 to 200 g/L
COPPER GLEAM CLX-A, B, manufactured by Rohm & Hass Co.: 5 to 10 mUL
Temperature: 25°C
Under air agitation

The present invention is explained by way of Examples. These Examples illustrate preferred examples and the present invention is not limited to these Examples. Accordingly, variations, other Examples or aspects included in technical ideas of the present invention are entirely included.
For comparison with the present invention, Comparative Examples were shown.

### (Example 1)

A polyimide resin with a 27.5 µm thick adhesive was used, and as a copper foil a 18 µm thick rolled copper foil containing 0.02% by mass of Ag, 0.02% by mass of oxygen and the remainder being Cu and inevitable impurities was used. A rolled copper foil was arranged on one surface of the polyimide resin, followed by thermo-compression bonding at 180°C for 60 minutes.
Next, copper was formed in a thickness of 10 µm on a rolled copper foil, bonded on one surface of the polyimide resin, at a current density of 1 A/dm² under the above copper plating conditions. The thickness of this plating layer was calculated by respectively subtracting known thicknesses of a resin film and a copper foil from the thickness of the entire laminate for flexible wiring (total thickness).

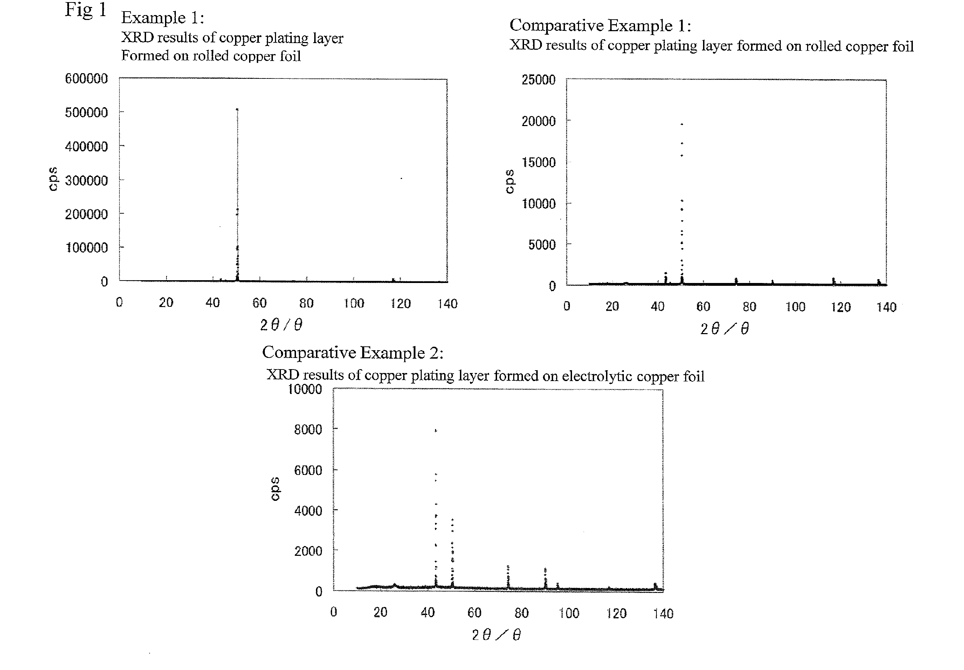

A laminate piece for flexible wiring in a size of 1 cm square was cut out from the obtained laminate sample sheet for flexible wiring of Example 1. The laminate piece for flexible wiring was mounted on an X-ray diffractometer (RINT2000, manufactured by Rigaku Co., Ltd.), and then an X-ray diffraction intensity was measured. From a peak intensity of each of peaks (111), (200), (220) and (311) identified as copper, an X-ray diffraction intensity ratio A = [(200)/{(111) + (200) + (220) + (311)}] × 100 was derived.
The results are shown in Fig. 1 (1). Each of the peak intensity, the total, and the value A are shown in Table 1. As shown in Fig. 1 (1), one peak (200) of XRD is clear. As shown in Table 1, a peak area intensity of (200) of XRD reached 36,536 and reached 97% (value A) of the total 37,530 of other peak area intensities.

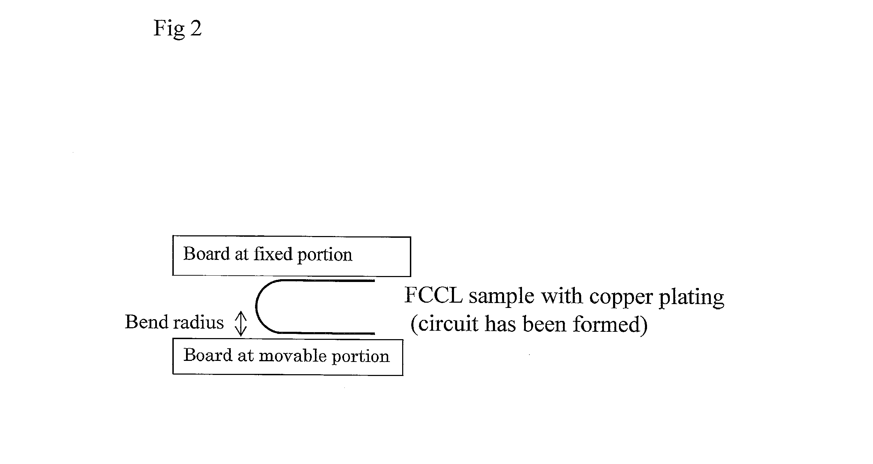

Next, a circuit in a common printed wiring board was formed on the laminate for flexible wiring which was copper plated thereon in Example 1. That is, a circuit was formed by the procedures of compression bonding of a resist film, exposure, etching and removal. Here, the circuit had line/space of 300 µm/300 µm.
With a circuit board that was produced using the laminate for flexible wiring, a bending test was carried out. A schematic diagram of a bending tester is shown in Fig. 2. Using a slide bending tester shown in Fig. 2, a sample of the circuit board on which the circuit has been formed was attached to the slide bending tester, with a polyimide resin surface faces outside and a circuit surface faces inside.

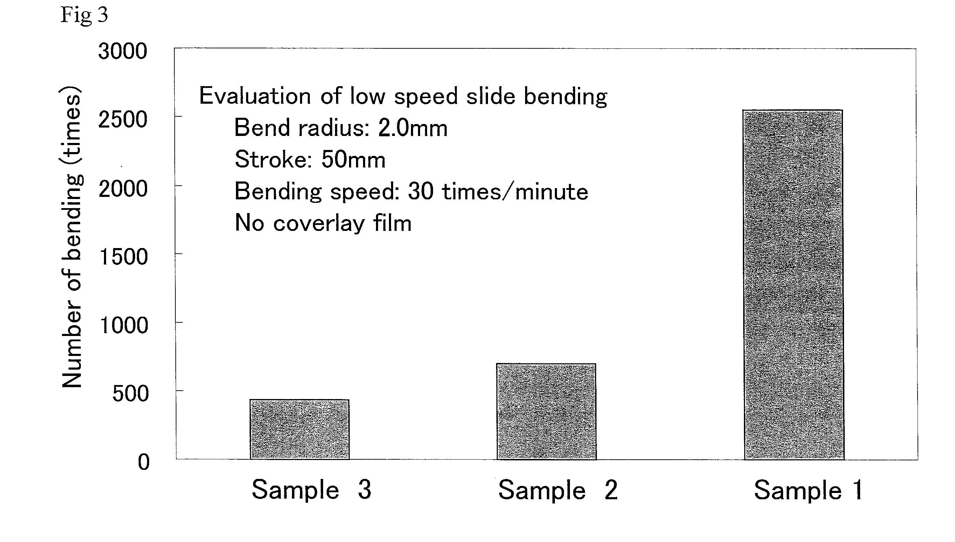

Then, bending evaluation was carried out under the conditions of a bend radius of 2.0 mm, a stroke of 50 mm and a bending speed of 30 times/minute. Here, the bend radius was set to one half of a distance between the two (upper and lower) boards, and the number of bending was set to the number of reciprocations of a board at movable portion within 1 minute. Upon bending evaluation, electric resistance of the circuit was simultaneously measured and the number of cycles at a point of time when a rate of increase in electric resistance becomes 20% or more was regarded as the number of cycles to fracture. The results are shown in Fig. 3. And, the number of bending until fracture occurs exceeded 2,500 times.

**Table 1**

| | XRD peak intensity | | | | | | |
|---|---|---|---|---|---|---|---|
| | (111) | (200) | (220) | (311) | (331) | Total | Value A |
| Example 1 | 629 | 36536 | 195 | 55 | 115 | 37530 | 97 |
| Example 2 | 382 | 47101 | 43 | 22 | 52 | 47601 | 99 |
| Com parative Example 1 | 1036 | 613 | 126 | 178 | 100 | 2053 | 30 |
| Comparative Example 2 | 163 | 2800 | 125 | 89 | 158 | 3336 | 84 |
| Comparative Example 3 | 1127 | 602 | 203 | 202 | 96 | 2230 | 27 |

### (Example 2)

A polyimide resin with a 27.5 µm thick adhesive was used as an insulating resin substrate, and a 18 µm thick rolled copper foil containing 0.02% by mass of Ag, 0.02% by mass of oxygen and the remainder being Cu and inevitable impurities was used as a copper foil. A rolled copper foil was arranged on one surface of the polyimide resin, followed by thermo-compression bonding at 180°C for 60 minutes.
Next, copper was formed in a thickness of 10 µm on a rolled copper foil, bonded on one surface of the polyimide resin, at a current density of 4 A/dm² under the above copper plating conditions. The thickness of this plating layer was calculated by respectively subtracting known thicknesses of a resin film and a copper foil from the thickness of the entire laminate for flexible wiring (total thickness).

A laminate piece for flexible wiring in a size of 1 cm square was cut out from the obtained laminate sample sheet for flexible wiring of Example 2. The laminate piece for flexible wiring was mounted on an X-ray diffractometer (RINT2000, manufactured by Rigaku Co., Ltd.), and then an X-ray diffraction intensity was measured. From a peak intensity of each peak (111), (200), (220) and (311) identified as copper, an X-ray diffraction intensity ratio A = [(200)/{(111) + (200) + (220) + (311)}] × 100 was derived.
Each of the peak intensity, the total, and the value A are shown in Table 1. As shown, a peak area intensity of (200) of XRD reached 47,101 and reached 99% (value A) of the total 47,601 of other peak area intensities.

Next, a circuit in a common printed wiring board was formed on the laminate for flexible wiring which was copper plated in Example 2. That is, a circuit was formed by the procedures of compression bonding of a resist film, exposure, etching and removal. Here, the circuit had line/space of 300 µm/300 µm.
With respect to a circuit board produced using this laminate for flexible wiring, a bending test was carried out. A schematic diagram of a bending tester is shown in Fig. 2. Using a slide bending tester shown in Fig. 2, a sample of the circuit board on which the circuit has been formed was attached to the slide bending tester such that a polyimide resin surface faces outside and a circuit surface faces inside.

Then, bending evaluation was carried out under the conditions of a bend radius of 2.0 mm, a stroke of 50 mm and a bending speed of 30 times/minute. Here, the bend radius was set to one half of a distance between two (upper and lower) boards, and the number of bending was set to the number of reciprocations of a board at movable portion within 1 minute. Upon bending evaluation, electric resistance of the circuit was simultaneously measured and the number of cycles at a point of time when a rate of increase in electric resistance becomes 20% or more was regarded as the number of cycles to fracture. The results are shown in Fig. 3. And, the number of bending until fracture occurs exceeded 2,500 times.

### (Comparative Example 1)

In Comparative Example 1, as an insulating resin substrate a polyimide resin with a 27.5 µm thick adhesive was used as with Example 1. And as a copper foil, a 18 µm thick rolled copper foil containing 0.02% by mass of Ag, 0.02% by mass of oxygen and the remainder being Cu and inevitable impurities was used. A rolled copper foil was arranged on one surface of the polyimide resin, followed by thermo-compression bonding at 180°C for 60 minutes.
Next, copper was formed in a thickness of 10 µm on a rolled copper foil, bonded on one surface of the polyimide resin, at a current density of 6 A/dm² under the above copper plating conditions. The thickness of this plating layer was calculated by respectively subtracting known thicknesses of a resin film and a copper foil from the thickness of the entire laminate for flexible wiring (total thickness).

A laminate piece for flexible wiring in a size of 1 cm square was cut out from the obtained laminate sample sheet for flexible wiring of Comparative Example 1. The laminate piece for flexible wiring was mounted on an X-ray diffractometer (RINT2000, manufactured by Rigaku Co., Ltd.), and then an X-ray diffraction intensity was measured. From a peak intensity of each of peaks (111), (200), (220) and (311) identified as copper, an X-ray diffraction intensity ratio A = [(200)/{(111) + (200) + (220) + (311)}] × 100 was derived.
Each of the peak intensity, the total, and the value A are shown in Table 1. As shown, a peak area intensity of (200) of XRD reached 613 and reached 30% (value A) of the total 2053 of other peak area intensities.

Next, a circuit in a common printed wiring board was formed on the laminate for flexible wiring which was copper plated of Comparative Example 1. That is, a circuit was formed by the procedures of compression bonding of a resist film, exposure, etching and removal. Here, the circuit had line/space of 300 µm/300 µm.
With respect to a circuit board produced using this laminate for flexible wiring, a bending test was carried out. A schematic diagram of a bending tester is shown in Fig. 2. Using a slide bending tester shown in Fig. 2, a sample of the circuit board on which the circuit has been formed was attached to the slide bending tester such that a polyimide resin surface faces outside and a circuit surface faces inside.

Then, bending evaluation was carried out under the conditions of a bend radius of 2.0 mm, a stroke of 50 mm and a bending speed of 30 times/minute. Here, the bend radius was set to one half of a distance between two (upper and lower) boards, and the number of bending was set to the number reciprocations of a board at movable portion within 1 minute. Upon bending evaluation, electric resistance of the circuit was simultaneously measured and the number of cycles at a point of time when a rate of increase in electric resistance becomes 20% or more was regarded as the number of cycles to fracture. The results are shown in Fig. 3. And, the number of bending until fracture occurs was about 1,500 times.

### (Comparative Example 2)

In Comparative Example 2, as with Example 1, a polyimide resin with a 27.5 µm thick adhesive was used as an insulating resin substrate, and a 18 µm thick rolled tough pitch copper foil was used as a copper foil.
A rolled copper foil was arranged on one surface of the polyimide resin, followed by thermo-compression bonding at 180°C for 60 minutes. Next, copper was formed in a thickness of 10 µm on a rolled copper foil, bonded on one surface of the polyimide resin, at a current density of 1 A/dm² under the above same copper plating conditions as in Example 1. The thickness of this plating layer was calculated in the same manner as in Example 1 by respectively subtracting known thicknesses of a resin film and a copper foil from the thickness of the entire laminate for flexible wiring (total thickness).

A laminate piece for flexible wiring in a size of 1 cm square was cut out from the obtained laminate sample sheet for flexible wiring of Comparative Example 2. The laminate piece for flexible wiring was mounted on an X-ray diffractometer (RINT2000, manufactured by Rigaku Co., Ltd.), and then an X-ray diffraction intensity was measured. From a peak intensity of each of peaks (111), (200), (220) and (311) identified as copper, an X-ray diffraction intensity ratio A = [(200)/{(111) + (200) + (220) + (311)}] × 100 was derived.
The results are shown in Fig. 1 (2). Each of the peak intensity, the total, and the value A are shown in Table 1. As shown in Fig. 1 (2), peaks other than the peak (200) of XRD existed. As shown in Table 1, a peak area intensity of (200) of XRD was 2,800 and was 84% (value A) of the total 3,336 of other peak area intensities. This deviated from the condition of the present invention.

Next, a circuit in a common printed wiring board was formed on the laminate for flexible wiring which was copper plated in Comparative Example 2. That is, a circuit was formed by the procedures of compression bonding of a resist film, exposure, etching and removal. Here, the circuit had line/space of 300 µm/300 µm.
With respect to a circuit board produced using this laminate for flexible wiring, a bending test was carried out using the same bending tester as in Example 1. A sample of the circuit board on which the circuit has been formed was attached to the slide bending tester such that a polyimide resin surface faces outside and a circuit surface faces inside.

Then, bending evaluation was carried out under the conditions of a bend radius of 2.0 mm, a stroke of 50 mm and a bending speed of 30 times/minute. Here, the bend radius was set to one half of a distance between two (upper and lower) boards, and the number of bending was set to the number reciprocations of a board at movable portion within 1 minute. Upon bending evaluation, electric resistance of the circuit was simultaneously measured and the number of cycles at a point of time when a rate of increase in electric resistance becomes 20% or more was regarded as the number of cycles to fracture. The results are shown in Fig. 3(2). And, the number of bending until fracture occurs did not exceed 1,000 times, and slightly exceeded 500 times.

### (Comparative Example 3)

In Comparative Example 3, as with Example 1, a polyimide resin with a 27.5 µm thick adhesive was used as an insulating resin substrate, and a 18 µm thick electrolytic rolled copper foil was used as a copper foil. An electrolytic rolled copper foil was arranged on one surface of the polyimide resin, followed by thermo-compression bonding at 180°C for 60 minutes.
Next, copper was formed in a thickness of 10 µm on an electrolytic rolled copper foil, bonded on one surface of the polyimide resin, at a current density of 1 A/dm² under the above same copper plating conditions as in Example 1. The thickness of this plating layer was calculated in the same manner as in Example 1 by respectively subtracting known thicknesses of a resin film and a copper foil from the thickness of the entire laminate for flexible wiring (total thickness).

A laminate piece for flexible wiring in a size of 1 cm square was cut out from the obtained laminate sample sheet for flexible wiring of Comparative Example 3. The laminate piece for flexible wiring was mounted on an X-ray diffractometer (RINT2000, manufactured by Rigaku Co., Ltd.), and then an X-ray diffraction intensity was measured. From a peak intensity of each of peaks (111), (200), (220) and (311) identified as copper, an X-ray diffraction intensity ratio A = [(200)/{(111) + (200) + (220) + (311)}] x 100 was derived.
The results are shown in Fig. 1 (3). Each of the peak intensity, the total, and the value A are shown in Table 1. As shown in Fig. 1 (3), a lot of other peaks other than the peak (200) of XRD existed. As shown in Table 1, a peak area intensity of (200) of XRD was 602 and was 27% (value A) of the total 2,230 of other peak area intensities. This drastically deviated from the condition of the present invention.

Next, a circuit in a common printed wiring board was formed on the laminate for flexible wiring which was copper plated of Comparative Example 3. That is, a circuit was formed by the procedures of compression bonding of a resist film, exposure, etching and removal. Here, the circuit had line/space of 300 µm/300 µm.
With respect to a circuit board produced using this laminate for flexible wiring, a bending test was carried out using the same bending tester as in Example 1. A sample of the circuit board on which the circuit has been formed was attached to the slide bending tester such that a polyimide resin surface faces outside and a circuit surface faces inside.

Then, bending evaluation was carried out under the conditions of a bend radius of 2.0 mm, a stroke of 50 mm and a bending speed of 30 times/minute. Here, the bend radius was set to one half of a distance between two (upper and lower) boards, and the number of bending was set to the number of reciprocations of a board at a movable portion within 1 minute. Upon bending evaluation, electric resistance of the circuit was simultaneously measured and the number of cycles at a point of time when a rate of increase in electric resistance becomes 20% or more was regarded as the number of cycles to fracture. The results are shown in Fig. 3(2). And, the number of bending until fracture occurs did not exceed 500 times, and bendability was drastically inferior.

### INDUSTRIALAPPLICABILITY

The present invention has excellent effect capable of providing a laminate for flexible wiring in which copper plating is entirely or locally applied on a copper foil cladded on an insulating resin substrate, and particularly a laminate for flexible wiring, which has high bendability and enables the formation of fine patterns, namely, high dense patterns of wiring. It is possible to provide a laminate for flexible wiring, which can be applied in either case where copper plating is entirely applied on a copper foil cladded on an insulating resin substrate, or copper plating is locally applied on the periphery of through-holes. The laminate for flexible wiring of the present invention is extremely useful as a laminate for flexible wiring since it can be applied to either a single-sided flexible wiring board or a double-sided flexible printed wiring board, and has high bendability and enables the formation of fine patterns, namely, high dense patterns of wiring.

## Claims

1. A laminate for flexible wiring in which copper plating is entirely or locally applied on a copper foil cladded on an insulating resin substrate, **characterized in that** a ratio A = [(200)/{(111) + (200) + (220) + (311)}] × 100, i.e. a ratio of an area intensity of a peak in the X-ray diffraction of the copper plating surface is more than 90.

2. The laminate for flexible wiring according to claim 1, wherein the copper plating has a thickness of 3 µm or more and 15 µm or less.

3. The laminate for flexible wiring according to claim 1 or 2, wherein a grain size in a cross section of the copper plating portion is 20 µm or more.

4. The laminate for flexible wiring according to any one of claims 1 to 3, wherein a grain size in a cross section of copper foil portion of the laminate for flexible wiring is 30 µm or more.

5. The laminate for flexible wiring according to any one of claims 1 to 4, wherein a ratio A = [(200)/{(111) + (200) + (220) + (311)}] × 100, i.e. a ratio of an area intensity of a peak in the X-ray diffraction of the copper foil after removing copper plating of a laminate for flexible wiring is 95 or more.

6. The laminate for flexible wiring according to any one of claims 1 to 5, wherein a copper foil, in which a ratio A = [(200)/{(111) + (200) + (220) + (311)}] × 100, i.e. a ratio of an area intensity of a peak in the X-ray diffraction after annealing at 350°C for 30 minutes is 95 or more, is used.

7. The laminate for flexible wiring according to any one of claims 1 to 6, wherein the copper foil is a rolled copper foil which contains 0.01 to 0.04% by mass of Ag, 0.01 to 0.05% by mass of oxygen and the remainder being Cu and inevitable impurities.
